# EUROPEAN PATENT SPECIFICATION

(11) **EP 4 456 126 B1**
(45) Date of publication and mention of the grant of the patent: **10.12.2025**
(21) Application number: 24169705.1
(22) Date of filing: 11.04.2024
(51) Int. Cl.: H01L 23/28, H05K 3/46, H01L 23/00, H01L 25/00, H01L 25/10, H01L 25/065, H01L 25/04, H01L 23/538, H01L 23/498, H01L 25/03, H01L 25/16, H01L 21/56, H01L 23/31, H05K 1/14, H05K 3/28, H05K 3/34, H05K 3/36

(54) **SEMICONDUCTOR DEVICE WITH RIGID-FLEX SUB-ASSEMBLY AND METHOD THEREFOR**
HALBLEITERBAUELEMENT MIT STARR-FLEXIBLER UNTERANORDNUNG UND VERFAHREN DAFÜR
DISPOSITIF SEMI-CONDUCTEUR AVEC SOUS-ENSEMBLE FLEX-RIGIDE ET PROCÉDÉ ASSOCIÉ

(30) Priority: 26.04.2023 US 202318307082
(43) Date of publication of application: 30.10.2024
(73) Proprietor: NXP USA, Inc., Austin TX 78735 (US)
(72) Inventor: VINCENT, Michael B, 5656AG Eindhoven (NL); Shah, Ankur Shailesh, 5656AG Eindhoven (NL); Kanth, Namrata, 5656AG Eindhoven (NL)
(74) Representative: Colaiuda, Antonella

(56) References cited:
- US-A1- 2004 150 107
- US-A1- 2022 173 048

## Description

### Background

### Field

This disclosure relates generally to semiconductor device packaging, and more specifically, to semiconductor devices with a rigid-flex sub-assembly and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

United States patent application, publication number US 2022/173048 discloses a semiconductor package device including a flexible carrier, a first chip, a second chip, a first molding layer, a first adhesive layer and a second molding layer. The flexible carrier has a flexible layer and a rigid layer. The flexible layer has a patterned build-up circuit. The rigid layer is connected to a portion surface of the flexible layer. The position that the flexible layer connected to the rigid layer is formed a first carrying part and a second carrying part. The region of the flexible layer between the first carrying part and the second carrying part without the rigid layer is formed as a first flexible part. The first chip is connected to the first carrying part by flip-chip manner and the second chip is connected to the second carrying part by flip-chip manner. The first molding layer covers the first chip and the second molding layer covers the second chip. The first adhesive layer is connected between the first molding layer and the second carrying part.

United States patent application, publication number US 2004, 150 107 discloses a stack package and a fabricating method thereof using a ball grid array semiconductor package(hereinafter, referred to as "BGA PKG"). The stack package can easily electrically connect the stacked BGA PKGs with each other by simplifying a stack structure between the BGA PKGs, and increase bonding reliability by improving bonding force bonded portions of solder balls of substrates.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified cross-sectional view, an example rigid-flex sub-assembly at a stage of manufacture in accordance with an embodiment.
FIG. 2 illustrates, in a simplified cross-sectional view, an example populated rigid-flex sub-assembly at a stage of manufacture in accordance with an embodiment.
FIG. 3 through FIG. 8 illustrate, in simplified cross-sectional views, an example semiconductor device with the rigid-flex sub-assembly at stages of manufacture in accordance with an embodiment.
FIG. 9 and FIG. 10 illustrate, in simplified cross-sectional views, alternative example semiconductor devices at a stage of manufacture in accordance with an embodiment.

### Detailed Description

Generally, there is provided, a semiconductor device with a rigid-flex sub-assembly. The semiconductor device includes a semiconductor die with the rigid-flex sub-assembly affixed to the backside of the semiconductor die. The rigid-flex sub-assembly includes a rigid portion (attached to the semiconductor die) and a flex portion. Distal regions of the flex portion are bent by way of a tool such that the distal regions are substantially coplanar with an active side surface of the semiconductor die. The semiconductor die and the rigid-flex sub-assembly of the semiconductor device are at least partially encapsulated with an encapsulant while on a carrier substrate. After removal of the carrier substrate, die pads of the semiconductor die and conductive surfaces at the distal regions of the flex portion are exposed. An interconnecting package substrate is applied over the exposed die pads at the active side of the semiconductor die and the exposed conductive surfaces at the distal regions of the flex portion. The package substrate is configured to interconnect the semiconductor die and the rigid-flex sub-assembly with a printed circuit board, for example. The rigid-flex sub-assembly includes connection pads formed at a top surface of the rigid portion. The connection pads are configured for attachment of one or more components such as semiconductor die, passive components, active components, antennas, connection sockets, and the like or connection to a redistribution layer, for example. The one or more components may be attached to the rigid-flex sub-assembly prior to encapsulation such that the one or more components may be at least partially encapsulated with the encapsulant. Alternatively, the connection pads may be exposed after encapsulation of the semiconductor die and the rigid-flex sub-assembly allowing for the one or more external components to be attached after encapsulation. By forming the semiconductor device with the rigid-flex sub-assembly in this manner, a more cost-effective 3D interconnect can be realized.

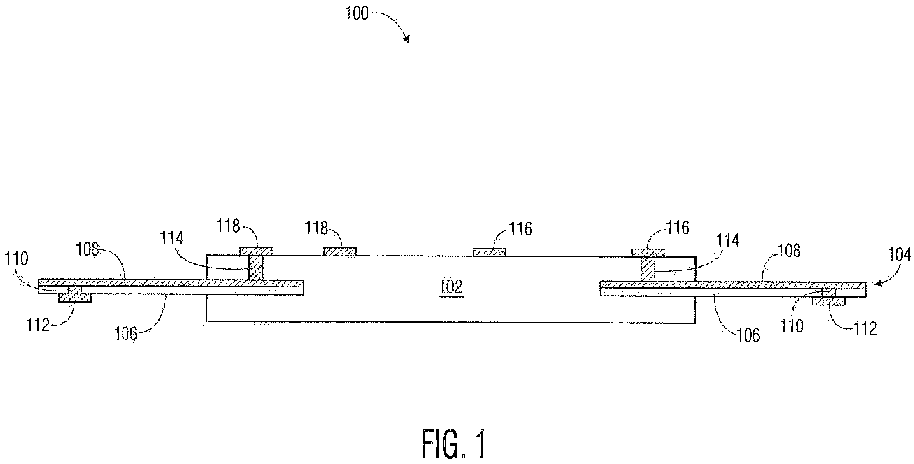

FIG. 1 illustrates, in a simplified cross-sectional view, an example rigid-flex sub-assembly 100 at a stage of manufacture in accordance with an embodiment. At this stage of manufacture, the rigid-flex sub-assembly 100 includes a rigid portion 102 and a flex portion 104. In this embodiment, the rigid portion 102 is formed from adhesive and rigid core materials. For example, the rigid portion 102 may include a non-conductive core FR4 layer sandwiched between non-conductive epoxy prepreg layers. The flex portion 104 is formed as patterned conductive traces 108 on a flexible non-conductive layer 106. For example, the flex portion 104 may include patterned copper traces formed on a flexible polyimide layer. In this embodiment, at least a portion of the conductive traces 108 is embedded in the rigid portion 102. In some embodiments, at least a portion of the conductive traces 108 may be on a top surface or a bottom surface of the rigid portion 102. The term "conductive," as used herein, generally refers to electrical conductivity unless otherwise described.

In this embodiment, distal regions of the flex portion 104 may include conductive flex pads 112 connected to the conductive traces 108 by way of conductive vias 110. The conductive flex pads are configured to provide a conductive surface for connection to traces of a package substrate formed at a subsequent stage, for example. In this embodiment, connection pads 116 and 118 may be formed at a top surface of the rigid portion 102. The connection pads 116 and 118 may be configured for attachment of one or more components or connection to a redistribution layer (RDL). The one or more components may be characterized as one or more of the following or combinations thereof: semiconductor die, passive components (e.g., resistor, capacitor, inductor), active components (e.g., diode, transistor), antennas, connection sockets, and the like. The connection pads 116 and 118 may be connected to proximal regions of the flex portion 104 embedded in the rigid portion 102 by way of conductive vias 114. The number, size, shape, and location of features of the rigid-flex sub-assembly 100 are chosen for illustration purposes. For example, the rigid-flex sub-assembly 100 may include any number connection pads 116 and 118 and associated conductive traces 108, arranged and interconnected accordingly.

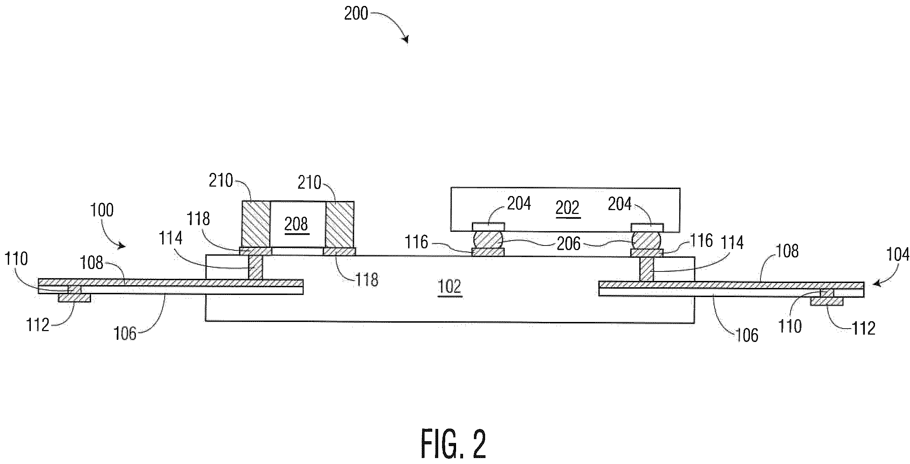

FIG. 2 illustrates, in a simplified cross-sectional view, an example populated rigid-flex sub-assembly 200 at a stage of manufacture in accordance with an embodiment. At this stage, the populated rigid-flex sub-assembly 200 includes two components affixed to the rigid-flex sub-assembly 100. In this embodiment, a semiconductor die 202 and a passive component 208 are mounted on the rigid-flex sub-assembly 100. Conductive bond pads 204 of the semiconductor die 202 are attached to the respective connection pads 116 of the rigid portion 102 by way of conductive die connectors 206, for example. The conductive die connectors 206 may be in the form of any suitable conductive structures such as gold studs, copper pillars, solder balls, and the like. Conductive pads (e.g., terminals) 210 of the passive component 208 are attached to the respective connection pads 118 by way of solder, solder paste, or conductive adhesive, for example. In some embodiments, the components (202, 208) may be affixed to the rigid-flex sub-assembly 100 at a subsequent stage of manufacture. For example, after a packaging encapsulation operation, the connection pads 116 and 118 may be exposed (e.g., by way of a film-assisted molding, etch, laser ablation, or other suitable process) allowing for the components to be affixed to respective connection pads 116 and 118 of the rigid-flex sub-assembly 100.

The semiconductor die 202 has an active side (e.g., major side having circuitry) and a backside (e.g., major side opposite of the active side). The semiconductor die 202 includes bond pads 204 formed at the active side. In this embodiment, semiconductor die 202 is configured in an active-side-down orientation with the active side mounted on the rigid portion 102 of the rigid-flex sub-assembly 100. The semiconductor die 202 may be formed from any suitable semiconductor material, such as silicon, germanium, gallium arsenide, gallium nitride, and the like. The semiconductor die 202 may further include any digital circuits, analog circuits, RF circuits, memory, processor, the like, and combinations thereof at the active side.

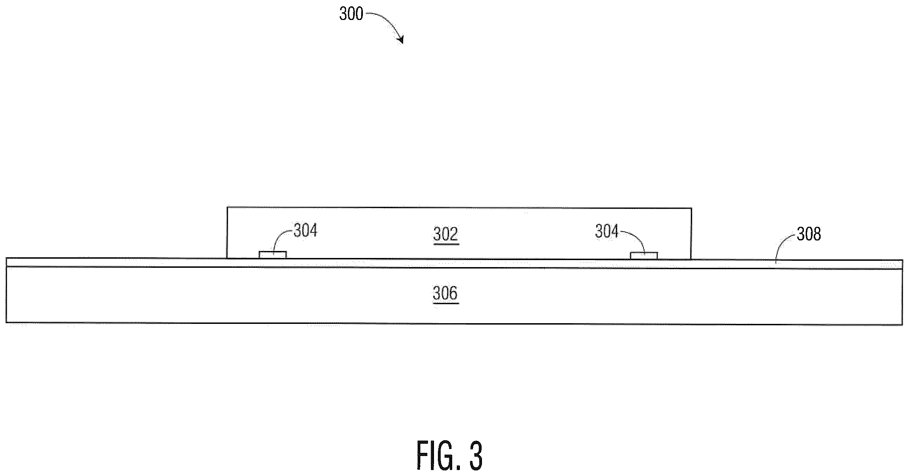

FIG. 3 through FIG. 8 illustrate, in simplified cross-sectional views, an example semiconductor device 300 including the populated rigid-flex sub-assembly 200 at stages of manufacture in accordance with an embodiment.

FIG. 3 illustrates, in a simplified cross-sectional view, the example semiconductor device 300 at a stage of manufacture in accordance with an embodiment. At this stage, the semiconductor device 300 includes a semiconductor die 302 placed on a carrier substrate 306. The carrier substrate 306 includes a releasable adhesive 308 applied at a top surface of the carrier substrate. The carrier substrate 306 is configured and arranged to provide a temporary rigid structure for placement of the semiconductor die 302 during encapsulation at a subsequent stage of manufacture, for example.

The semiconductor die 302 has an active side (e.g., major side having circuitry) and a backside (e.g., major side opposite of the active side). The semiconductor die 302 includes bond pads 304 formed at the active side. The bond pads 304 may be configured for connection to a package substrate formed at a subsequent stage, for example. In this embodiment, semiconductor die 302 is configured in an active-side-down orientation with the active side placed onto the carrier substrate 306. The semiconductor die 302 may be formed from any suitable semiconductor material, such as silicon, germanium, gallium arsenide, gallium nitride, and the like. The semiconductor die 302 may further include any digital circuits, analog circuits, RF circuits, memory, processor, the like, and combinations thereof at the active side.

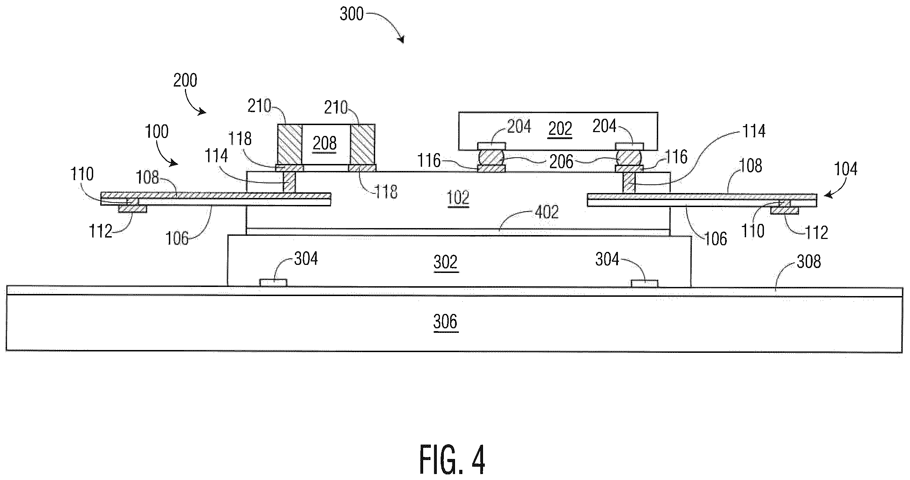

FIG. 4 illustrates, in a simplified cross-sectional view, the example semiconductor device 300 at a subsequent stage of manufacture in accordance with an embodiment. At this stage, the semiconductor device 300 includes the populated rigid-flex sub-assembly 200 attached to the semiconductor die 302. In this embodiment, a bottom surface of the rigid portion 102 of the populated rigid-flex sub-assembly 200 is affixed to the backside of the semiconductor die 302 by way of a die attach material 402. The die attach material may be in the form of a paste, film (e.g., die attach film, DAF), or other suitable die attach material. In some embodiments, it may be desirable to affix the unpopulated rigid-flex sub-assembly 100 of FIG. 1 to the semiconductor die 302 rather than the populated rigid-flex sub-assembly 200 such that the components may be attached at a subsequent stage of manufacture.

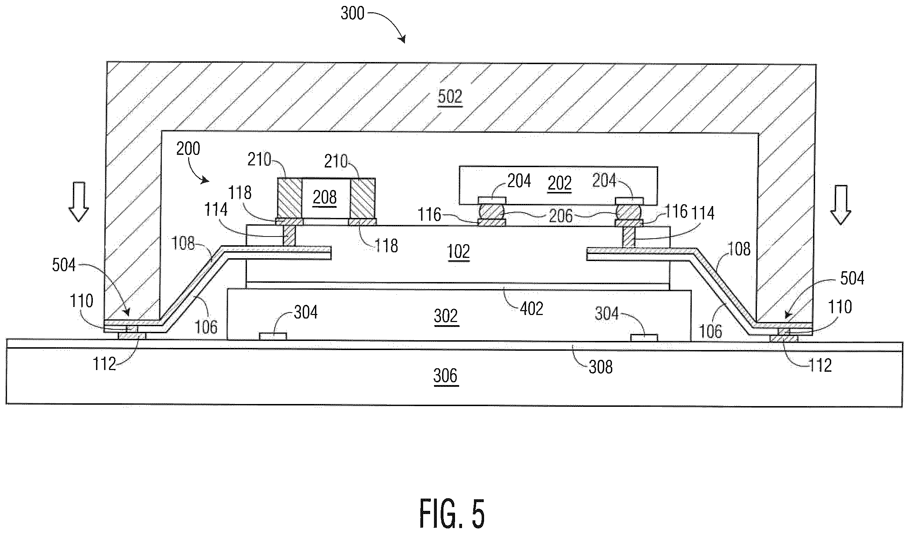

FIG. 5 illustrates, in a simplified cross-sectional view, the example semiconductor device 300 at a subsequent stage of manufacture in accordance with an embodiment. At this stage, the semiconductor device 300 includes the flex portion 104 of FIG. 4 bent such that a distal region 504 of the flex portion is in contact with the adhesive 308 of the carrier substrate 306. In this embodiment, a forming tool 502 engages with the distal regions 504 in a downward motion causing the distal regions 504 to adhere to the adhesive 308 of the carrier substrate 306. Conductive surfaces (e.g., conductive flex pads 112) at the distal region 504 are substantially coplanar with the surface of the active side of the semiconductor die 302 on the carrier substrate 306. In some embodiments, one or more distal regions 504 of the flex portion may be bent upward such that conductive surface portions of the distal regions 504 may be exposed at a top surface of an encapsulant molded at a subsequent stage of manufacture.

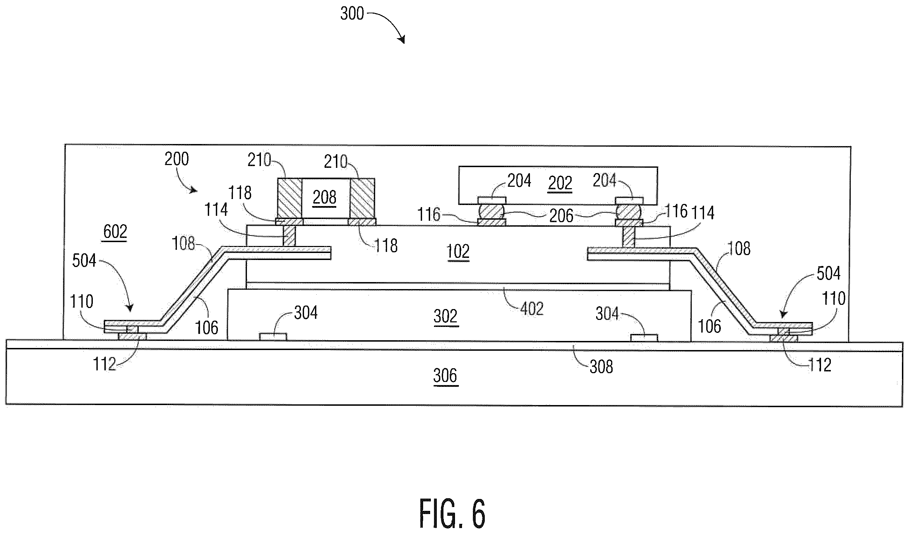

FIG. 6 illustrates, in a simplified cross-sectional view, the example semiconductor device 300 at a subsequent stage of manufacture in accordance with an embodiment. At this stage, the semiconductor device 300 includes the semiconductor die 302 and the populated rigid-flex sub-assembly 200 at least partially encapsulated with an encapsulant 602 while temporarily affixed on the carrier substrate 306. In this embodiment, the semiconductor die 302 and the populated rigid-flex sub-assembly 200 are over-molded with the encapsulant 602 by way of a molding process. The encapsulant 602 may be an epoxy molding compound dispensed during an injection molding encapsulation operation, for example. Alternatively, the semiconductor die 302 and the populated rigid-flex sub-assembly 200 may be molded with the encapsulant 602 by way of a film-assisted molding (FAM) process. For example, a FAM tool using a conformal film may be engaged with predetermined portions of the components (e.g., backside of the semiconductor die 202) of the populated rigid-flex sub-assembly 200 during the molding process to keep the predetermined portions free from encapsulant. In this manner, the backside of the semiconductor die 202, for example, may be exposed for subsequent attachment of heatsink.

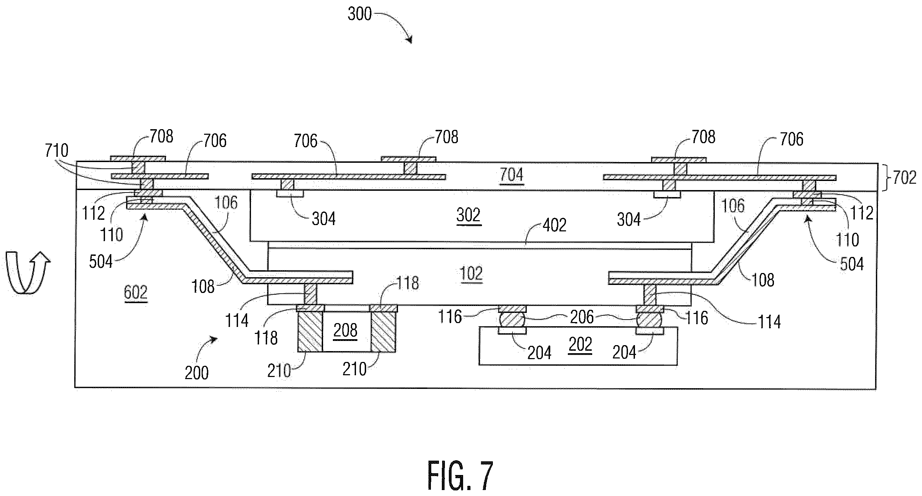

FIG. 7 illustrates, in a simplified cross-sectional view, the example semiconductor device 300 at a subsequent stage of manufacture in accordance with an embodiment. At this stage, the semiconductor device 300 is separated from the carrier substrate 306 of FIG. 6, reoriented (e.g., flipped), and an interconnecting package substrate 702 is applied over the exposed active side of the semiconductor die 302 and distal regions 504 of the flex portion of the populated rigid-flex sub-assembly 200. The active side of the semiconductor die 302 including the die pads 304 and conductive surface portions (e.g., conductive flex pads 112) of the distal regions 504 are exposed when the carrier substrate is removed. After the active side of the semiconductor die 302 and conductive surface portions of the distal regions 504 are exposed, the package substrate 702 is applied. The package substrate 702 includes conductive features (e.g., patterned copper traces 706-708, vias 710) surrounded by non-conductive material 704 (e.g., dielectric). The package substrate 702 may be formed as a build-up substrate or may be provided as a pre-formed substrate. The package substrate 702 may be characterized as a redistribution layer (RDL) substrate formed over and interconnecting the exposed die pads 304 of the semiconductor die 302 and conductive surface of the of the bent distal region 504.

In this embodiment, the conductive traces 706-708 and the conductive vias 710 of the package substrate 702 are formed to interconnect the semiconductor die 302 and the populated rigid-flex sub-assembly 200 with a printed circuit board (PCB), for example. Exposed portions of the conductive traces 708 are configured for attachment of conductive connectors at a subsequent stage of manufacture.

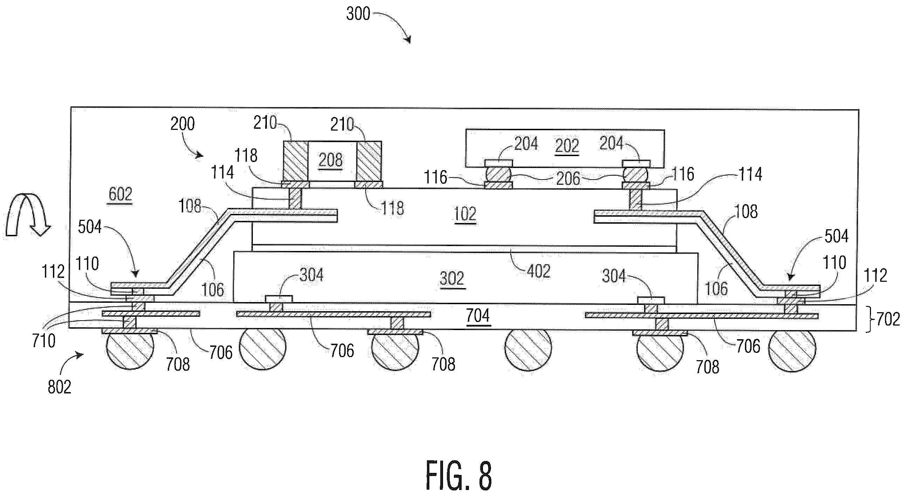

FIG. 8 illustrates, in a simplified cross-sectional view, the example semiconductor device 300 at a subsequent stage of manufacture in accordance with an embodiment. At this stage, conductive connectors 802 (e.g., solder balls) are affixed to a bottom side of the package substrate 702. The conductive connectors 802 are configured and arranged to provide conductive connections between the semiconductor device 300 and a PCB, for example. The conductive connectors 802 may be in the form of any suitable conductive structures such as solder balls, gold studs, copper pillars, and the like, to connect conductive features of the semiconductor device 300 with the PCB. As an alternative to attaching conductive connectors 802, the exposed portions of conductive traces 708 may be plated for subsequent connection with the PCB by way of solder paste attachment or other suitable conductive attachment processes (e.g., ACF, ACP). After the conductive connectors 802 are affixed on the package substrate 702, the semiconductor device 300 is reoriented (e.g., flipped back).

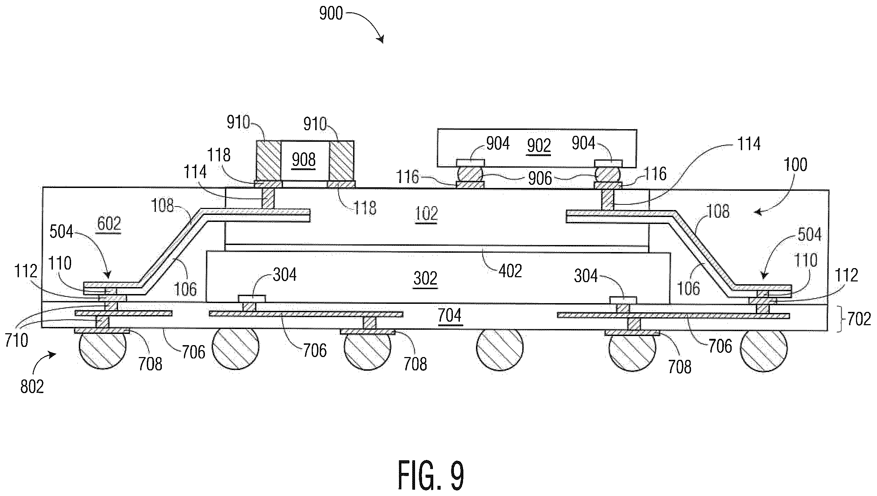

FIG. 9 illustrates, in a simplified cross-sectional view, an alternative example semiconductor device 900 at a stage of manufacture in accordance with an embodiment. In this embodiment, the stages of manufacture depicted in FIG. 1 and FIGs. 3-5 remain substantially similar with the components (e.g., semiconductor die 902 and passive component 908) affixed to the rigid-flex sub-assembly 100 after encapsulation. For example, the (unpopulated) rigid-flex sub-assembly 100 of FIG. 1 is affixed to the backside of the semiconductor die 302 in FIGs. 4 and 5 as an alternative to the populated rigid-flex sub-assembly 200 of FIG. 2.

In this embodiment, the semiconductor device 900 includes the semiconductor die 302 and the unpopulated rigid-flex sub-assembly 100 at least partially encapsulated, having the components attached to the connection pads 116 and 118 of the rigid-flex sub-assembly 100 after encapsulation. The semiconductor die 302 and the rigid-flex sub-assembly 100 are over-molded with the encapsulant 602 by way of a molding process. The encapsulant 602 may be an epoxy molding compound dispensed during an injection molding encapsulation operation, for example. In some embodiments, the connection pads 116 and 118 at the top surface of the rigid portion 102 may be exposed by way of back-grinding after encapsulation. Alternatively, the semiconductor die 302 and the rigid-flex sub-assembly 100 may be molded with the encapsulant 602 by way of a FAM process. For example, a FAM tool using a conformal film may be engaged with the top surface of the rigid portion 102 of the rigid-flex sub-assembly 100 during the molding process to keep the connection pads 116 and 118 free from encapsulant. In this manner, the connection pads 116 and 118 may be exposed without a back-grinding operation.

After encapsulating the semiconductor die 302 and the rigid-flex sub-assembly 100 with the encapsulant 602 (and after removal of the carrier substrate), the interconnecting package substrate 702 is applied over the exposed active side of the semiconductor die 302 and distal regions 504 of the flex portion of the rigid-flex sub-assembly. The package substrate 702 includes conductive features (e.g., patterned copper traces 706-708, vias 710) surrounded by non-conductive material 704 (e.g., dielectric). The package substrate 702 may be formed as a build-up substrate or may be provided as a pre-formed substrate. The package substrate 702 may be characterized as a redistribution layer (RDL) substrate formed over and interconnecting the exposed die pads 304 of the semiconductor die 302 and conductive surface of the of the bent distal region 504. The conductive traces 706-708 and the conductive vias 710 of the package substrate 702 are formed to interconnect the semiconductor die 302 and the rigid-flex sub-assembly 100 with a PCB by way of conductive connectors 802 (e.g., solder balls) affixed to exposed portions of the conductive traces 708, for example. The conductive connectors 802 may be in the form of any suitable conductive structures such as solder balls, gold studs, copper pillars, and the like, to connect conductive features of the semiconductor device 900 with the PCB.

After encapsulating the semiconductor die 302 and the rigid-flex sub-assembly 100 with the encapsulant 602 (and after the connection pads 116 and 118 are exposed), the components (e.g., semiconductor die 902 and passive component 908) are affixed to the rigid-flex sub-assembly 100. Conductive bond pads 904 of the semiconductor die 902 are attached to the respective connection pads 116 of the rigid portion 102 by way of conductive die connectors 906, for example. The conductive die connectors 906 may be in the form of any suitable conductive structures such as gold studs, copper pillars, solder balls, and the like. Conductive pads (e.g., terminals) 910 of the passive component 908 are attached to the respective connection pads 118 by way of solder, solder paste, or conductive adhesive, for example.

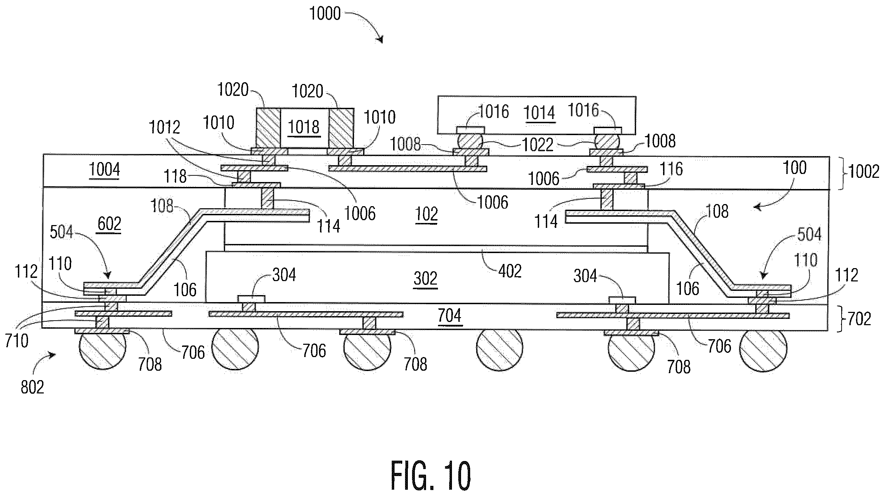

FIG. 10 illustrates, in a simplified cross-sectional view, another alternative example semiconductor device 1000 at a stage of manufacture in accordance with an embodiment. In this embodiment, the stages of manufacture depicted in FIG. 1 and FIGs. 3-5 remain substantially similar with the components (e.g., semiconductor die 1014 and passive component 1018) affixed to the rigid-flex sub-assembly 100 by way of a second package substrate 1002 formed after encapsulation. For example, the rigid-flex sub-assembly 100 of FIG. 1 is affixed to the backside of the semiconductor die 302 in FIGs. 4 and 5 as an alternative to the populated rigid-flex sub-assembly 200 of FIG. 2.

In this embodiment, the semiconductor device 1000 includes the semiconductor die 302 and the rigid-flex sub-assembly 100 at least partially encapsulated, having the second interconnecting package substrate 1002 formed after encapsulation. The semiconductor die 302 and the rigid-flex sub-assembly 100 are over-molded with the encapsulant 602 by way of a molding process. In some embodiments, the connection pads 116 and 118 at the top surface of the rigid portion 102 may be exposed by way of back-grinding after encapsulation. Alternatively, the semiconductor die 302 and the rigid-flex sub-assembly 100 may be molded with the encapsulant 602 by way of a FAM process to keep the connection pads 116 and 118 free from encapsulant.

After encapsulating the semiconductor die 302 and the rigid-flex sub-assembly 100 with the encapsulant 602 (and after removal of the carrier substrate), the interconnecting package substrate 702 is applied over the exposed active side of the semiconductor die 302 and distal regions 504 of the flex portion of the rigid-flex sub-assembly. The package substrate 702 includes conductive features (e.g., patterned copper traces 706-708, vias 710) surrounded by non-conductive material 704 (e.g., dielectric). The package substrate 702 may be formed as a build-up substrate or may be provided as a pre-formed substrate. The package substrate 702 may be characterized as a redistribution layer (RDL) substrate formed over and interconnecting the exposed die pads 304 of the semiconductor die 302 and conductive surface of the of the bent distal region 504. The conductive traces 706-708 and the conductive vias 710 of the package substrate 702 are formed to interconnect the semiconductor die 302 and the rigid-flex sub-assembly 100 with a PCB by way of conductive connectors 802 (e.g., solder balls) affixed to exposed portions of the conductive traces 708, for example. The conductive connectors 802 may be in the form of any suitable conductive structures such as solder balls, gold studs, copper pillars, and the like, to connect conductive features of the semiconductor device 1000 with the PCB.

After encapsulating the semiconductor die 302 and the rigid-flex sub-assembly 100 with the encapsulant 602 (and after the connection pads 116 and 118 are exposed), the interconnecting package substrate 1002 is applied over the exposed connection pads 116 and 118 at the rigid portion 102 of the rigid-flex sub-assembly 100. The package substrate 1002 includes conductive features (e.g., patterned copper traces 1006-1010, vias 1012) surrounded by non-conductive material 1004 (e.g., dielectric). The package substrate 1002 may be formed as a build-up substrate or may be provided as a pre-formed substrate. The package substrate 1002 may be characterized as a second RDL substrate formed over and interconnecting the exposed connection pads 116 and 118 at the rigid portion 102 of the rigid-flex sub-assembly 100. The conductive traces 1006-1010 and the conductive vias 1012 of the package substrate 1002 are formed to interconnect the rigid-flex sub-assembly 100 with one or more components or a second PCB affixed to exposed portions of the conductive traces 1008 and 1010, for example. The one or more components may be characterized as one or more of the following or combinations thereof: semiconductor die, passive components (e.g., resistor, capacitor, inductor), active components (e.g., diode, transistor), antennas, connection sockets, and the like.

In this embodiment, the components (e.g., semiconductor die 1014 and passive component 1018) are affixed to the package substrate 1002. Conductive bond pads 1016 of the semiconductor die 1014 are attached to the respective conductive traces 1008 of the package substrate 1002 by way of conductive die connectors 1022, for example. The conductive die connectors 1022 may be in the form of any suitable conductive structures such as gold studs, copper pillars, solder balls, and the like. Conductive pads (e.g., terminals) 1020 of the passive component 1018 are attached to the respective conductive traces 1010 of the package substrate 1002 by way of solder, solder paste, or conductive adhesive, for example.

Generally, there is provided, a method including placing a semiconductor die on a carrier substrate; affixing a rigid-flex sub-assembly on the semiconductor die, the rigid-flex sub-assembly including a rigid portion, and a flex portion including a conductive trace; bending a distal region of the flex portion such that the bent distal region is not coplanar with the rigid portion; and encapsulating with an encapsulant at least a portion of the semiconductor die and the rigid-flex sub-assembly. The rigid-flex sub-assembly may further include a plurality of connection pads, at least one of the connection pads conductively connected to the conductive trace. The method includes affixing a first component on the rigid-flex sub-assembly, a conductive pad of the first component conductively connected to the conductive trace. The encapsulating with the encapsulant further includes encapsulating at least a portion of the first component. The first component affixed on the rigid-flex sub-assembly may be characterized as a second semiconductor die. The method further includes affixing a second component on the rigid-flex sub-assembly, the second component characterized as a passive component. The method may further include removing the carrier substrate to expose die pads of the semiconductor die and conductive surface of the bent distal region of the flex portion; and forming a redistribution layer (RDL) substrate over the exposed die pads of the semiconductor die and conductive surface of the of the bent distal region. The rigid portion may be formed from non-conductive epoxy prepreg and FR4 materials. The flex portion may include the conductive trace formed on a flexible non-conductive material.

In another embodiment, there is provided, a method including placing an active side of a semiconductor die on a carrier substrate; affixing a rigid-flex sub-assembly on a backside of the semiconductor die, the rigid-flex sub-assembly including a rigid portion, and a flex portion including a conductive trace, at least a portion of the conductive trace embedded in the rigid portion; bending a distal region of the flex portion such that the distal region is substantially coplanar with an active side of the semiconductor die and contacts the carrier substrate; and encapsulating with an encapsulant at least a portion of the semiconductor die and the rigid-flex sub-assembly. The method may further include removing the carrier substrate to expose die pads of the semiconductor die and conductive surface of the bent distal region of the flex portion; and forming a first redistribution layer (RDL) substrate over the exposed die pads of the semiconductor die and conductive surface of the of the bent distal region. The rigid-flex sub-assembly may further include a plurality of conductive connection pads, a first connection pad of the plurality of connection pads conductively connected to the conductive trace. The method may further include affixing a component on the rigid-flex sub-assembly, a conductive pad of the component conductively connected to the first connection pad. The encapsulating with the encapsulant may further include encapsulating at least a portion of the component. The method may further include forming a second RDL substrate over an exposed surface of the rigid-flex sub-assembly, a conductive trace of the second RDL substrate interconnected to the first connection pad of the plurality of connection pads.

In yet another embodiment, there is provided, a semiconductor device including a semiconductor die having an active side and a backside opposite of the active side; a rigid-flex sub-assembly attached on a backside of the semiconductor die, the rigid-flex sub-assembly including a rigid portion, and a flex portion including a conductive trace, at least a portion of the conductive trace embedded in the rigid portion; a distal region of the flex portion bent such that the distal region is substantially coplanar with the active side of the semiconductor die; and an encapsulant encapsulating at least a portion of the semiconductor die and the rigid-flex sub-assembly. The semiconductor device may further include a redistribution layer (RDL) substrate formed over the active side of the semiconductor die and conductive surface of the of the bent distal region of the flex portion, conductive traces of the RDL substrate interconnected to die pads of the semiconductor die and conductive surface of the bent distal region. The semiconductor device may further include a component affixed on the rigid-flex sub-assembly, a conductive pad of the component conductively connected to the conductive trace. The encapsulant may further encapsulate at least a portion of the component. The component affixed on the rigid-flex sub-assembly may be characterized as a second semiconductor die.

By now, it should be appreciated that there has been provided a semiconductor device with a rigid-flex sub-assembly. The semiconductor device includes a semiconductor die with the rigid-flex sub-assembly affixed to the backside of the semiconductor die. The rigid-flex sub-assembly includes a rigid portion (attached to the semiconductor die) and a flex portion. Distal regions of the flex portion are bent by way of a tool such that the distal regions are substantially coplanar with an active side surface of the semiconductor die. The semiconductor die and the rigid-flex sub-assembly of the semiconductor device are at least partially encapsulated with an encapsulant while on a carrier substrate. After removal of the carrier substrate, die pads of the semiconductor die and conductive surfaces at the distal regions of the flex portion are exposed. An interconnecting package substrate is applied over the exposed die pads at the active side of the semiconductor die and the exposed conductive surfaces at the distal regions of the flex portion. The package substrate is configured to interconnect the semiconductor die and the rigid-flex sub-assembly with a printed circuit board, for example. The rigid-flex sub-assembly includes connection pads formed at a top surface of the rigid portion. The connection pads are configured for attachment of one or more components such as semiconductor die, passive components, active components, antennas, connection sockets, and the like or connection to a redistribution layer, for example. The one or more components may be attached to the rigid-flex sub-assembly prior to encapsulation such that the one or more components may be at least partially encapsulated with the encapsulant. Alternatively, the connection pads may be exposed after encapsulation of the semiconductor die and the rigid-flex sub-assembly allowing for the one or more external components to be attached after encapsulation. By forming the semiconductor device with the rigid-flex sub-assembly in this manner, a more cost-effective 3D interconnect can be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
placing a semiconductor die (302) on a carrier substrate (306);
affixing a rigid-flex sub-assembly (200) on the semiconductor die, the rigid-flex sub-assembly comprising:
a rigid portion (102); and
a flex portion (104) including a conductive trace (108);
bending a distal region (504) of the flex portion such that the bent distal region is not coplanar with the rigid portion;
encapsulating with an encapsulant (602) at least a portion of the semiconductor die and the rigid-flex sub-assembly;
affixing a first component on the rigid-flex sub-assembly, a conductive pad (204) of the first component conductively connected to the conductive trace; and
affixing a second component on the rigid-flex sub-assembly, the second component characterized as a passive component.

2. The method of claim 1, wherein the rigid-flex sub-assembly further includes a plurality of connection pads (116, 118), at least one of the connection pads conductively connected to the conductive trace.

3. The method of claim 1 or 2, wherein encapsulating with the encapsulant further includes encapsulating at least a portion of the first component.

4. The method of any preceding claim, wherein the first component affixed on the rigid-flex sub-assembly is characterized as a second semiconductor die.

5. The method of any preceding claim, further comprising:
removing the carrier substrate to expose die pads of the semiconductor die and conductive surface of the bent distal region of the flex portion; and
forming a redistribution layer, RDL, substrate over the exposed die pads of the semiconductor die and conductive surface of the of the bent distal region.

6. The method of any preceding claim, wherein the rigid portion is formed from non-conductive epoxy prepreg and FR4 materials.

7. The method of any preceding claim, wherein the flex portion includes the conductive trace formed on a flexible non-conductive material.

8. A semiconductor device (300) comprising:
a semiconductor die (302) having an active side and a backside opposite of the active side;
a rigid-flex sub-assembly (200) attached on a backside of the semiconductor die, the rigid-flex sub-assembly comprising:
a rigid portion (102); and
a flex portion (104) including a conductive trace (108), at least a portion of the conductive trace embedded in the rigid portion;
a distal region (504) of the flex portion bent such that the distal region is substantially coplanar with the active side of the semiconductor die; and
an encapsulant (602) encapsulating at least a portion of the semiconductor die and the rigid-flex sub-assembly.

9. The semiconductor device of claim 8, further comprising a redistribution layer, RDL, substrate formed over the active side of the semiconductor die and conductive surface of the of the bent distal region of the flex portion, conductive traces of the RDL substrate interconnected to die pads of the semiconductor die and conductive surface of the bent distal region.

10. The semiconductor device of claim 8 or 9, further comprising a component affixed on the rigid-flex sub-assembly, a conductive pad of the component conductively connected to the conductive trace.

11. The semiconductor device of claim 10, wherein the encapsulant further encapsulates at least a portion of the component.

12. The semiconductor device of claim 10 or 11, wherein the component affixed on the rigid-flex sub-assembly is characterized as a second semiconductor die.

## Patentansprüche

1. Verfahren, das Folgendes umfasst:
Anordnen eines Halbleiterchips (302) auf einem Trägersubstrat (306);
Befestigen einer Starrflex-Unterbaugruppe (200) auf dem Halbleiterchip, wobei die Starrflex-Unterbaugruppe Folgendes umfasst:
einen starren Abschnitt (102); und
einen flexiblen Abschnitt (104), der eine leitfähige Bahn (108) enthält;
Biegen eines distalen Bereichs (504) des flexiblen Abschnitts, derart, dass der gebogene distale Bereich nicht zum starren Bereich komplanar ist;
Verkapseln zumindest eines Abschnitts des Halbleiterchips und der Starrflex-Unterbaugruppe mit einem Verkapselungsmaterial (602);
Befestigen einer ersten Komponente auf der Starrflex-Unterbaugruppe, wobei eine leitfähige Kontaktfläche (204) der ersten Komponente mit der leitfähigen Bahn leitfähig verbunden wird; und
Befestigen einer zweiten Komponente auf der Starrflex-Unterbaugruppe, wobei die zweite Komponente als eine passive Komponente charakterisiert ist.

2. Verfahren nach Anspruch 1, wobei die Starrflex-Unterbaugruppe ferner mehrere Verbindungskontaktflächen (116, 118) enthält, wobei mindestens eine der Verbindungskontaktflächen mit der leitfähigen Bahn leitfähig verbunden ist.

3. Verfahren nach Anspruch 1 oder 2, wobei das Verkapseln mit dem Verkapselungsmaterial ferner das Verkapseln zumindest eines Abschnitts der ersten Komponente enthält.

4. Verfahren nach einem der vorhergehenden Ansprüche, wobei die erste Komponente, die auf der Starrflex-Unterbaugruppe befestigt ist, als ein zweiter Halbleiterchip charakterisiert ist.

5. Verfahren nach einem der vorhergehenden Ansprüche, das ferner Folgendes umfasst:
Entfernen des Trägersubstrats, um die Kontaktflächen des Halbleiterchips und die leitfähige Fläche des gebogenen distalen Bereichs des flexiblen Abschnitts freizulegen;
und
Bilden eines Umverdrahtungsschicht-Substrats, RDL-Substrats, über den freiliegenden Chipkontaktflächen des Halbleiterchips und der leitfähigen Fläche des gebogenen distalen Bereichs.

6. Verfahren nach einem der vorhergehenden Ansprüche, wobei der starre Abschnitt aus nicht leitfähigen Epoxid-Prepreg- und FR4-Materialien gebildet wird.

7. Verfahren nach einem der vorhergehenden Ansprüche, wobei der flexible Abschnitt die leitfähige Bahn enthält, die auf einem flexiblen, nicht leitfähigen Material gebildet ist.

8. Halbleitervorrichtung (300), die Folgendes umfasst:
einen Halbleiterchip (302), der eine aktive Seite und eine Rückseite, die der aktiven Seite gegenüberliegt, aufweist;
eine Starrflex-Unterbaugruppe (200), die auf einer Rückseite des Halbleiterchips angebracht ist, wobei die Starrflex-Unterbaugruppe Folgendes umfasst:
einen starren Abschnitt (102); und
einen flexiblen Abschnitt (104), der eine leitfähige Bahn (108) enthält, wobei zumindest ein Abschnitt der leitfähigen Bahn im starren Abschnitt eingebettet ist;
einen distalen Bereich (504) des flexiblen Abschnitts, der derart gebogen ist, dass der distale Bereich im Wesentlichen zur aktiven Seite des Halbleiterchips komplanar ist; und
ein Verkapselungsmaterial (602), das zumindest einen Abschnitt des Halbleiterchips und der Starrflex-Unterbaugruppe verkapselt.

9. Halbleitervorrichtung nach Anspruch 8, die ferner ein Umverdrahtungsschicht-Substrat, RDL-Substrat, umfasst, das über der aktiven Seite des Halbleiterchips und der leitfähigen Fläche des gebogenen distalen Bereichs des flexiblen Abschnitts gebildet ist, wobei leitfähige Bahnen des RDL-Substrats mit Chipkontaktflächen des Halbleiterchips und der leitfähigen Fläche des gebogenen distalen Bereichs gekoppelt sind.

10. Halbleitervorrichtung nach Anspruch 8 oder 9, die ferner eine Komponente umfasst, die auf der Starrflex-Unterbaugruppe befestigt ist, wobei eine leitfähige Kontaktfläche der Komponente mit der leitfähigen Bahn leitfähig verbunden ist.

11. Halbleitervorrichtung nach Anspruch 10, wobei das Verkapselungsmaterial ferner zumindest einen Abschnitt der Komponente verkapselt.

12. Halbleitervorrichtung nach Anspruch 10 oder 11, wobei die Komponente, die auf der Starrflex-Unterbaugruppe befestigt ist, als ein zweiter Halbleiterchip charakterisiert ist.

## Revendications

1. Procédé comprenant :
la mise en place d'une puce semi-conductrice (302) sur un substrat support (306) ;
la fixation d'un sous-ensemble rigide-flexible (200) sur la puce semi-conductrice, le sous-ensemble rigide-flexible comprenant :
une partie rigide (102) ; et
une partie flexible (104) comprenant une piste conductrice (108) ;
le pliage d'une région distale (504) de la partie flexible de manière à ce que la région distale pliée ne soit pas coplanaire avec la partie rigide ;
l'encapsulation, au moyen d'un encapsulant (602), d'au moins une partie de la puce semi-conductrice et du sous-ensemble rigide-flexible ;
la fixation d'un premier composant sur le sous-ensemble rigide-flexible, un plot conducteur (204) du premier composant étant connecté de manière conductrice à la piste conductrice ; et
la fixation d'un deuxième composant sur le sous-ensemble rigide-flexible, le deuxième composant étant caractérisé comme un composant passif.

2. Procédé selon la revendication 1, dans lequel le sous-ensemble rigide-flexible comporte en outre une pluralité de plots de connexion (116, 118), au moins un des plots de connexion étant connecté de manière conductrice à la piste conductrice.

3. Procédé selon la revendication 1 ou 2, dans lequel l'encapsulation au moyen de l'encapsulant comporte en outre l'encapsulation d'au moins une partie du premier composant.

4. Procédé selon l'une quelconque des revendications précédentes, dans lequel le premier composant fixé sur le sous-ensemble rigide-flexible est caractérisé comme une deuxième puce semi-conductrice.

5. Procédé selon l'une quelconque des revendications précédentes, comprenant en outre :
l'élimination du substrat support pour rendre apparents les plots de connexion de la puce semi-conductrice et la surface conductrice de la région distale pliée de la partie flexible ; et
la formation d'un substrat à couche de redistribution, RDL, par-dessus des plots de connexion rendus apparents de la puce semi-conductrice et la surface conductrice de la région distale pliée.

6. Procédé selon l'une quelconque des revendications précédentes, dans lequel la partie rigide est formée à partir de matériaux non conducteurs de type préimprégné époxy et FR4.

7. Procédé selon l'une quelconque des revendications précédentes, dans lequel la partie flexible comporte la piste conductrice formée sur un matériau flexible non conducteur.

8. Dispositif à semi-conducteur (300) comprenant :
une puce semi-conductrice (302) présentant un côté actif et un côté arrière opposé au côté actif ;
un sous-ensemble rigide-flexible (200) fixé sur un côté arrière de la puce semi-conductrice, le sous-ensemble rigide-flexible comprenant :
une partie rigide (102) ; et
une partie flexible (104) comportant une piste conductrice (108), au moins une partie de la piste conductrice étant noyée dans la partie rigide ;
une région distale (504) de la partie flexible pliée de manière à ce que la région distale soit sensiblement coplanaire avec le côté actif de la puce semi-conductrice ; et
un encapsulant (602) encapsulant au moins une partie de la puce semi-conductrice et du sous-ensemble rigide-flexible.

9. Dispositif à semi-conducteur selon la revendication 8, comprenant en outre un substrat à couche de redistribution, RDL, formé par-dessus le côté actif de la puce semi-conductrice et la surface conductrice de la région distale pliée de la partie flexible, des pistes conductrices du substrat RDL étant interconnectées à des plots de connexion de la puce semi-conductrice et à la surface conductrice de la région distale pliée.

10. Dispositif à semi-conducteur selon la revendication 8 ou 9, comprenant en outre un composant fixé sur le sous-ensemble rigide-flexible, un plot conducteur du composant étant connecté de manière conductrice à la piste conductrice.

11. Dispositif à semi-conducteur selon la revendication 10, dans lequel l'encapsulant encapsule en outre au moins une partie du composant.

12. Dispositif à semi-conducteur selon la revendication 10 ou 11, dans lequel le composant fixé sur le sous-ensemble rigide-flexible est caractérisé comme une deuxième puce semi-conductrice.
